# NEW EUROPEAN PATENT SPECIFICATION

(11) **EP 2 393 122 B2**
(45) Date of publication and mention of the opposition decision: **26.12.2018**
(45) Mention of the grant of the patent: 30.03.2016
(21) Application number: 10735801.2
(22) Date of filing: 26.01.2010
(51) Int. Cl.: H01L 27/142, H01L 31/046

(54) **PHOTOELECTRIC CONVERSION CELL, PHOTOELECTRIC CONVERSION MODULE, AND METHOD FOR MANUFACTURING PHOTOELECTRIC CONVERSION CELL**
PHOTOELEKTRISCHE UMWANDLUNGSZELLE, PHOTOELEKTRISCHES UMWANDLUNGSMODUL UND VERFAHREN ZUR HERSTELLUNG EINER PHOTOELEKTRISCHEN UMWANDLUNGSZELLE
CELLULE DE CONVERSION PHOTOÉLECTRIQUE, MODULE DE CONVERSION PHOTOÉLECTRIQUE, ET PROCÉDÉ DE FABRICATION DE CELLULE DE CONVERSION PHOTOÉLECTRIQUE

(30) Priority: 29.01.2009 JP 2009018410
(43) Date of publication of application: 07.12.2011
(73) Proprietor: Kyocera Corporation, Kyoto-shi Kyoto 612-8501 (JP)
(72) Inventor: MIYAUCHI, Koji, Higashiomi-shi Shiga 527-8555 (JP)
(74) Representative: Viering, Jentschura & Partner mbB Patent- und Rechtsanwälte
(86) International application number: PCT/JP2010/050967
(87) International publication number: WO 2010/087333

(56) References cited:
- EP-A2- 0 749 161
- WO-A1-2008/015900
- DE-C1- 3 714 920
- DE-T5-112007 000 269
- JP-A- 2 237 080
- JP-A- 62 084 569
- JP-A- 2000 299 486
- JP-A- 2006 245 502
- US-A- 4 542 255
- US-A- 4 652 693
- US-A- 5 981 864
- US-A1- 2004 219 801
- US-B1- 7 122 398
- KESSLER J; ET AL: 'NEW WORLD RECORD CU(IN,GA)SE2 BASED MINI-MODULE : 16.6%' CONFERENCE PROCEEDINGS ARTICLE vol. CONF.16, 01 May 2000, pages 2057 - 2060, XP001139076
- RETTERSTOL OLAISEN, BIRGER ET AL: 'CIGC MINI-MODULES WITH SCREEN PRINTED FRONT CONTACTS' 15TH INTERN. PHOTOVOLTAIC SCIENCE & ENG.CONF. 2005,
- WENNERBERG, J. ET AL: 'DESIGN OF GRIDED CU(IN,GA)SE"2 THIN-FILM PV MODULES' SOLAR ENERGY MATERIALS AND SOLAR CE vol. 67, no. 1-4, 01 March 2001, pages 59 - 65, XP004224742
- KESSLER ET AL: 'HIGHLY EFFICIENT CU(IN, GA)SE2 MINI-MODULES' SOLAR ENERGY MATERIALS & SOLAR CELLS vol. 75, 2003, pages 35 - 46
- LÖFFLER, J. ET AL: 'MONOLITHIC SERIES INTERCONNECTION FOR THIN FILM SILICON SOLAR CELLS ON STEEL FOIL' 23RD EUROPEAN PHOTOVOLTAIC SOLAR ENERGY CONFERENCE September 2008,
- WENNERBERG, J.: 'DESIGN AND STABILITY OF CU(IN, GA)SE2-BASED SOLAR CELL MODULES' COMPR. SUMMARIES OF UPPSALA DISSERTATIONS FAC. OF SCIENCE vol. 683, 2002, UPPSALA, ISSN 1104-232X
- BURGERS, A.R.: 'HOW TO DESIGN OPTIMAL METALLIZATION PATTERNS FOR SOLAR CELLS' PROGRESS IN PHOTOVOLTAICS: RESEARCH AND APPLICATIONS vol. 7, no. 6, 01 November 1999, pages 457 - 461, XP000958148
- WENNERBERG J: 'THIN FILM PV MODULES FOR LOW-CONCENTRATING SYSTEMS' SOLAR ENE vol. 69, 01 July 2001, pages 243 - 255, XP004303024
- WESTIN, P.-O.: 'NEXT GENERATION INTERCONNECTIVE LASER PATTERNING OF CIGS THIN FILM MODULES' SOLAR ENERGY MATERIALS AND SOLAR CELLS vol. 95, no. 4, 22 November 2010, pages 1062 - 1068, XP028148513
- 'MECHANICAL SCRIBING OF GRIDED ELECTRODE CIGS CELLS' EXPERIMENTAL STUDY PERFORMED AT SOLIBRO AB August 2017 - September 2017,
- BAHL, S.: 'NUMERICAL SIMULATION AND EXPERIMENTAL INVESTIGATIONS FOR MECHANICAL SCRIBING OF CU(IN,GA)SE2 THIN-FILM SOLAR CELLS' THESIS AT MARTIN-LUTHER-UNIVERSITÄT, HALLE-WITTENBERG 02 March 2016,

## Description

### TECHNICAL FIELD

The present invention relates to a photoelectric conversion cell for absorbing light to generate power and a photoelectric conversion module including a plurality of photoelectric conversion cells.

### BACKGROUND ART

There is known a photoelectric conversion module such as a solar cell in which a photoelectric conversion cell having a transparent electrode layer on a light receiving surface is set to be a constitutional unit and the photoelectric conversion cells are serially connected on a substrate such as a glass. Moreover, the solar cell described in Patent Document JP2000299486 A is structured such that by providing a metallic wiring on a transparent electrode layer to suppress a reduction in power loss along with a decrease in a thickness of the transparent electrode layer while decreasing the thickness of the transparent electrode layer in order to increase a transmission rate of light, thereby enhancing a power generation efficiency of the solar battery cell.

With the structure of the solar cell described in the Patent Document JP2000299486 A however, there is a fear that a broken part may be generated in an outer peripheral part of the cell and a photoelectric conversion cannot be efficiently carried out in the outer peripheral part, resulting in a fear of a reduction in power generation efficiency.

Therefore, there are demanded a photoelectric conversion cell and a photoelectric conversion module which can suppress the reduction in the power generation efficiency.

Patent Documents DE112007000269 T5, EP0749161 A2, DE3714920 C1 disclose a photoelectric conversion cell comprising two separated electrode layers, with two semiconductor layers on them forming a p-n junction, a connecting part for electrically connecting the second upper semiconductor layer to the second electrode layer; and a linear electrode which is positioned on the second semiconductor layer and reaches a first end of the second semiconductor layer. Patent Document US5981864 discloses a photoelectric conversion cell comprising two separated electrode layers, with two semiconductor layers on them forming a p-n junction, a transparent conductive layer on them and a connecting part connecting the second upper semiconductor layer to the second electrode layer, a plurality of linear electrodes on the transparent electrode that reach only one end of the semiconductor layers.

### SUMMARY OF THE INVENTION

A photoelectric conversion cell according to the present invention is defined in claim 1.

A photoelectric conversion module according to an embodiment of the present invention is given in claim 7.

A method for manufacturing a photoelectric conversion cell according to an embodiment of the preset invention is given in claim 8.

### BRIEF DESCRIPTION OF THE DRAWINGS

FIG. 1 is a perspective view showing a photoelectric conversion cell and a photoelectric conversion module according to a first embodiment of the present invention.
FIG. 2 is a sectional view showing the photoelectric conversion cell and the photoelectric conversion module shown in FIG. 1.
FIGS. 3A to 3E are sectional views showing a method of manufacturing the photoelectric conversion cell and the photoelectric conversion module shown in FIG. 1 in every step.
FIG. 4 is a perspective view showing a photoelectric conversion cell and a photoelectric conversion module according to a second embodiment of the present invention.
FIG. 5 is a sectional view showing the photoelectric conversion cell and the photoelectric conversion module shown in FIG. 4.
FIGS. 6A to 6E are sectional views showing a method of manufacturing a photoelectric conversion cell and a photoelectric conversion module according to an example not forming part of the invention.

### EMBODIMENT FOR CARRYING OUT THE INVENTION

Embodiments according to the present invention will be described below in detail with reference to the drawings.

First of all, description will be given to a photo-electric conversion cell and a photoelectric conversion module according to a first embodiment of the present invention.

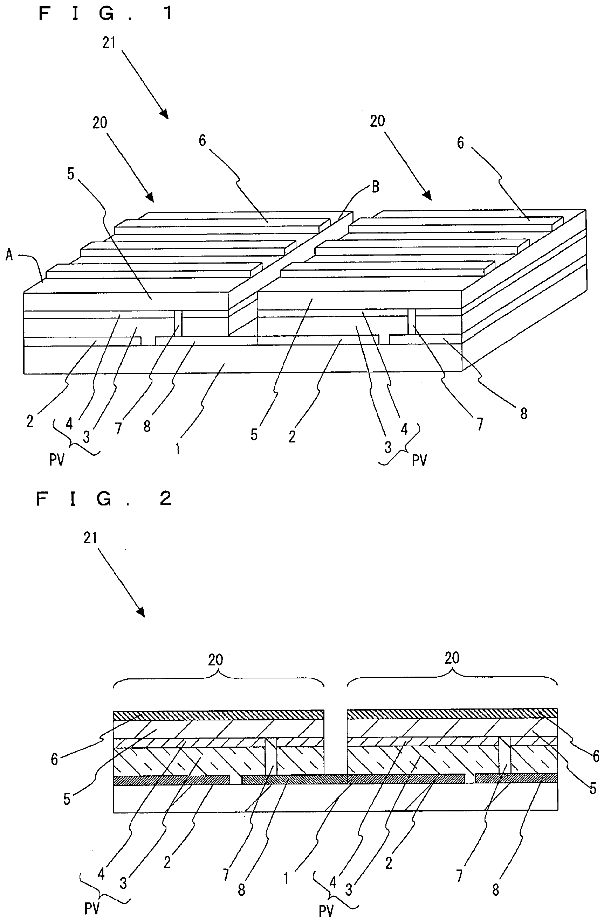

FIG. 1 is a view showing a structure of a photoelectric conversion cell 20 and a photoelectric conversion module 21 using the same according to the first embodiment of the present invention. Moreover, FIG. 2 is a sectional view showing the photoelectric conversion cell 20 and the photoelectric conversion module 21. The photoelectric conversion cell 20 includes a substrate 1, a first electrode layer 2, a second electrode layer 8, a first semiconductor layer 3, a second semiconductor layer 4, a conductive layer 5, a linear electrode 6, and a connecting part 7. Moreover, the first semiconductor layer 3 and the second semiconductor layer 4 constitute a photoelectric conversion layer PV.

The photoelectric conversion module 21 is constituted by arranging a plurality of photoelectric conversion cells 20. The second electrode layer 8 in one of the photoelectric conversion cells 20 which are adjacent to each other and the first electrode layer 2 of the other photoelectric conversion cell 20 are electrically connected to each other. By the structure, it is possible to easily connect the photoelectric conversion cells 20 which are adjacent to each other in series. In one of the photoelectric conversion cells 20, the connecting part 7 is provided to divide the photoelectric conversion layer PV. In other words, in FIG. 1, the connecting part 7 is formed like a railway from a side surface at a front side of the photoelectric conversion cell 20 to a side surface at a back side opposed thereto, and a photoelectric conversion is carried out through the photoelectric conversion layer PV interposed between the first electrode layer 2 and the conductive layer 5 which are positioned on a left side of the connecting part 7.

The substrate 1 serves to support the photoelectric conversion cell 20. Examples of a material to be used for the substrate 1 include glass, ceramics, a resin, a metal and the like. In a case where the photoelectric conversion module 21 is constituted, the photoelectric conversion cell 20 may be provided on each of the substrates 1, they may be arranged and connected to each other in series or the photoelectric conversion cells 20 may be provided on a single substrate 1. In the case where the photoelectric conversion cells 20 are provided on the single substrate 1, thus, the photoelectric conversion module 21 can easily be fabricated.

A conductor such as Mo, Al, Ti or Au is used for the first electrode layer 2 and the second electrode layer 8, and they are formed on the substrate 1 through sputtering, evaporation or the like. In FIG. 1, in the adjacent photoelectric conversion cells 20, the second electrode layer 8 of one of the photoelectric conversion cells 20 and the first electrode layer 2 of the other photoelectric conversion cell 20 comprise an integral structure.

The photoelectric conversion layer PV includes the first semiconductor layer 3 and the second semiconductor layer 4 and can absorb light and convert the light into power, and a semiconductor material which is of a silicon type, a compound semiconductor type or the like is used. Examples of the silicon type include single crystal silicon, polysilicon, amorphous silicon and the like. The compound semiconductor type includes a single crystal type and a polycrystal type, and examples of the compound semiconductor type can include a III-V group compound semiconductor, a II-VI group compound semiconductor, a chalcopyrite type (referred to as a CIS type) compound semiconductor, and the like.

In respect of a reduction in a material, it is preferable that the photoelectric conversion layer PV should be a thin film having a thickness of 10 µm or less. Also in the case where the photoelectric conversion layer PV is set to be the thin film, it is possible to effectively suppress an occurrence of a broken part in the outer peripheral portion of the photoelectric conversion layer PV by the structure in which the linear electrode 6 reaches a first end A of the photoelectric conversion layer PV as in the present embodiment.

The photoelectric conversion layer PV using the chalcopyrite type compound semiconductor of the thin film photoelectric conversion layers PV to be the thin films has a high conversion efficiency. Therefore, it is possible to achieve a photoelectric conversion efficiency which is almost equal to that of the conventional single crystal silicon even if the photoelectric conversion layer PV is the thin film, and so the photoelectric conversion layer PV using the chalcopyrite type compound semiconductor is particularly preferable. In respect of the fact that hazardous cadmium is not contained, similarly, the photoelectric conversion layer PV using the chalcopyrite type compound semiconductor is preferable. Examples of the chalcopyrite type compound semiconductor include Cu(In, Ga)Se₂ (referred to as CIGS), Cu(In, Ga)(Se, S)₂ (referred to as CIGSS), and CuInS₂ (referred to as CIS). The photoelectric conversion layer PV is formed by sputtering, evaporation, coating or the like if it is fabricated by the thin film, for example. Cu(In, Ga)Se₂ is a compound constituted mainly by Cu, In, Ga and Se. Moreover, Cu(In, Ga) (Se, S)₂ is a compound constituted mainly by Cu, In, Ga, Se and S.

The first semiconductor layer 3 and the second semiconductor layer 4 have different conductivity types, that is, one of them has an n type and the other has a p type, and they are subjected to a pn junction. The first semiconductor layer 3 may have the p-type and the second semiconductor layer 4 may have the n-type, and a reverse relationship can be taken. The pn junction of the first semiconductor layer 3 and the second semiconductor layer 4 is not restricted to a direct junction of the first semiconductor layer 3 and the second semiconductor layer 4. For example, another semiconductor layer having the same conductivity type as the first semiconductor layer 3 or another semiconductor layer having the same conductivity type as the second semiconductor layer 4 may further be provided therebetween. Moreover, a pin junction may include an i-type semiconductor layer provided between the first semiconductor layer 3 and the second semiconductor layer 4.

The first semiconductor layer 3 and the second semiconductor layer 4 may make a homojunction or heterojunction. Examples of the heterojunction include CdS, ZnS, ZnO, In₂Se₃, In(OH, S), (Zn, In)(Se, OH), (Zn, Mg)O and the like (which are generally referred to as buffer layers) as the second semiconductor layer 4 in the case where the first semiconductor layer 3 is a chalcopyrite type compound semiconductor such as CIGS (which is generally referred to as an optical absorption layer), for example. The second semiconductor layer 4 is formed by chemical bus deposition (CBD) or the like, for instance. In(OH, S) indicates a compound constituted mainly by In, OH and S. (Zn, In)(Se, OH) indicates a compound constituted mainly by Zn, In, Se and OH. (Zn, Mg)O indicates a compound constituted mainly by Zn, Mg and O.

The conductive layer 5 may be provided on the second semiconductor layer 4 as shown in FIG. 1. Consequently, it is possible to take out an electric charge generated in the photoelectric conversion layer PV more satisfactorily. Thus, the power generation efficiency can be enhanced more greatly. A conductor such as ITO, ZnO : A1 or the like is used for the conductive layer 5, and the conductive layer 5 is formed by sputtering, evaporation, chemical vapor deposition (CVD) or the like. In the case where the conductive layer 5 side is used as a light receiving surface, it is preferable that the conductive layer 5 should have a light transmission properties to absorbed light of the photoelectric conversion layer PV in order to enhance an absorption efficiency of the photoelectric conversion layer PV. In respect of enhancing light transmission properties and favorable transmitting a current generated by the photoelectric conversion to the linear electrode 6 simultaneously, it is preferable that the conductive layer 5 should have a thickness of 0.05 to 0.5 µm.

The linear electrode 6 is formed on or above the second semiconductor layer 4 and serves to reduce an electrical resistance, thereby taking out an electric charge generated in the second semiconductor layer 4 well, and acts as a collecting electrode. The linear electrode 6 is provided like a railway in order to prevent light to the photoelectric conversion layer PV from being shielded. The linear electrode 6 taking the shape of the railway is provided to reach the first end A of the second semiconductor layer 4, that is, the end A of the photoelectric conversion layer PV in a planar view. By the structure, the linear electrode 6 protects the outer peripheral portion of the photoelectric conversion layer PV, thereby suppressing the occurrence of the broken part in the outer peripheral portion of the photoelectric conversion layer PV. Thus, it is possible to carry out an excellent photoelectric conversion also in the outer peripheral portion of the photoelectric conversion layer PV. Moreover, it is possible to efficiently take out a current generated in the outer peripheral portion of the photoelectric conversion layer PV by the linear electrode 6 reaching the first end A. As a result, it is possible to enhance the power generation efficiency.

Thus, the outer peripheral portion of the photo-electric conversion layer PV can be protected by the linear electrode 6 reaching the first end A. Therefore, it is possible to decrease a total thickness of members provided between the first electrode layer 2 and the linear electrode 6. Accordingly, it is possible to reduce the members and to shorten the steps of fabricating them. It is preferable that the total thickness of the members provided between the first electrode layer 2 and the linear electrode 6 (a total thickness of the first semiconductor layer 3, the second semiconductor layer 4 and the conductive layer 5 in the examples of FIGS. 1 and 2) should be thin, that is, 1.56 to 2.7 µm. More specifically, in the examples of FIGS. 1 and 2, it is preferable that the thickness of the first semiconductor layer 3 should be 1.5 to 2.0 µm, the thickness of the second semiconductor layer 4 should be 0.01 to 0.2 µm and the thickness of the conductive layer 5 should be 0.05 to 0.5 µm.

Moreover, an end face of the linear electrode 6, an end face of the conductive layer 5 and an end face of the photoelectric conversion layer PV are on a same plane at the first end A side to which the linear electrode 6 reaches. Consequently, the current converted photoelectrically through the first end A of the photoelectric conversion layer PV can be taken out well.

The arrival of the linear electrode 6 at the first end A of the second semiconductor layer 4 represents the perfect arrival of the linear electrode 6 at the first end A on an outermost side of the second semiconductor layer 4, in order to effectively suppress a progress of a crack in the first end A of the second semiconductor layer 4 set as a base point, thereby suppressing a broken part, and in respect of an enhancement in a collecting effect at the first end A through the linear electrode 6.

In order to prevent a light to the photoelectric conversion layer PV from being shielded and to suppress the broken part of the outer peripheral portion of the photoelectric conversion layer PV, it is preferable that the linear electrode 6 should have a width of 50 to 400 µm. Moreover, the linear electrode 6 may comprise a plurality of branched portions.

It is preferable that the linear electrode 6 should be formed by printing a metallic paste such as Ag (a mixture of metallic particles and a resin) in a pattern and curing the metallic paste, for example. In other words, it is preferable that the linear electrode 6 should contain the metallic particles and the resin. Consequently, a durability to a bending stress of the linear electrode 6 subjected to the curing is enhanced. As a result, the outer peripheral portion of the photoelectric conversion layer PV can be protected well.

It is preferable that the linear electrode 6 should contain a solder. Consequently, it is possible to enhance the durability to the bending stress, and furthermore, to reduce a resistance more greatly. More preferably, the linear electrode 6 contains metals of two types or more of different melting points. In this case, the linear electrode 6 is preferably heated and cured at a temperature at which at least one of these metals melts, and at least one of the remaining metals does not melt. Consequently, a metal having a low melting point is molten so that the liner electrode 6 is caused to be compact, resulting in a reduction in a resistance, and furthermore, a metal having a high melting point can suppress a spread of the molten metal in the heating and curing.

The photoelectric conversion cells 20 are arranged and connected electrically so that the photoelectric conversion module 21 can be obtained. In order to easily connect the adjacent photoelectric conversion cells 20 in series, the photoelectric conversion cell 20 comprises the structure in which the second semiconductor layer 4 and the second electrode layer 8 are electrically connected to each other through the connecting part 7 provided in the photoelectric conversion layer PV as shown in FIGS. 1 and 2. Although the conductive layer 5 is provided to cause the electrical connection of the second semiconductor layer 4 and the second electrode layer 8 to have a higher conductivity in FIG. 1, the present invention is not restricted thereto but it is also possible to employ a structure in which the conductive layer 5 is not formed.

It is preferable that the connecting part 7 should be formed simultaneously and integrated in the formation of the conductive layer 5. In other words, the conductive layer 5 comprises a first extended portion which is extended from the second semiconductor layer 4 toward the second electrode layer 8, and the conductive layer 5 constitutes the connecting part 7 through the connection of the first extended portion to the second electrode layer 8. Consequently, it is possible to simplify the process, and furthermore, to enhance an electrical connecting reliability.

When the other end opposed to the first end A in the ends of the photoelectric conversion layer PV which the linear electrode 6 reaches is set to be a second end B, it is preferable that the connecting part 7 should be positioned on the side of the second end B, that is, in the vicinity of the second end B from the first end A of the photoelectric conversion layer PV in a planar view if the linear electrode 6 is extended from the first end A toward the second end B. It is more preferable that the connecting part 7 should be almost parallel with the second end B of the photoelectric conversion layer PV in a planar view and should be extended linearly. By the structure, the connecting part 7 can be caused to approach the second end B to reduce a size of a region between the connecting part 7 and the second end B which does not contribute to power generation and serves as a dead space. Consequently, it is possible to enhance a photo-electric conversion efficiency.

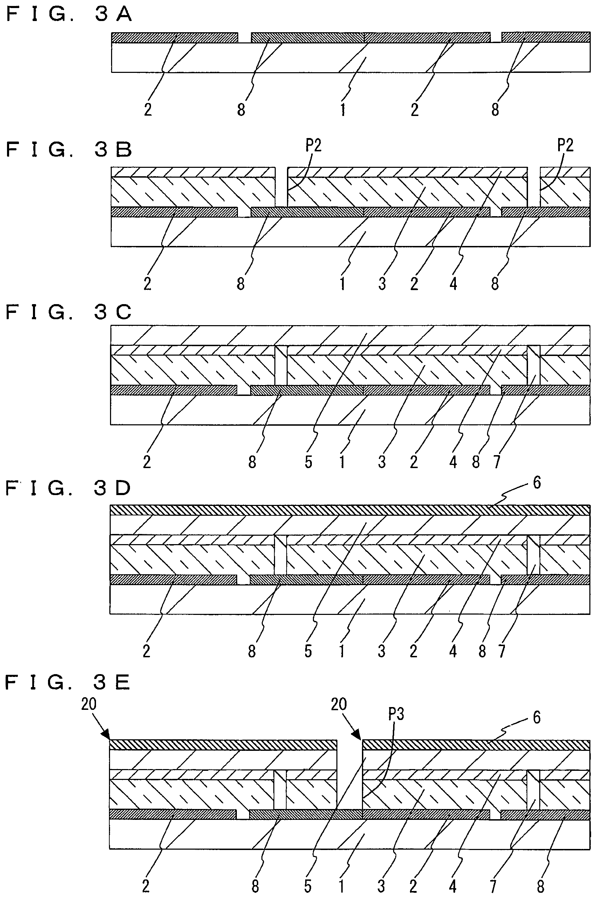

The photoelectric conversion cell 20 can be manufactured in the following manner. FIGS. 3A to 3E are sectional views showing the steps of manufacturing the photoelectric conversion cell 20, respectively.

First of all, as shown in Fig. 3A, the first electrode layer 2 and the second electrode layer 8 which have a desirable pattern are formed on the substrate 1. The first electrode layer 2 and the second electrode layer 8 in a pattern can be formed by using a thin film forming method such as sputtering and a pattern forming method such as scribing or etching.

As shown in Fig. 3B, next, the first semiconductor layer 3 and the second semiconductor layer 4 are laminated on the substrate 1, the first electrode layer 2 and the second electrode layer 8 by using a thin film forming method such as sputtering or CBD. Then, a through groove P2 for forming the connecting part 7 is formed on the first semiconductor layer 3 and the second semiconductor layer 4 through scribing, etching or the like.

As shown in FIG. 3C, subsequently, the conductive layer 5 is formed on the second semiconductor layer 4, and at the same time, the first extended portion to be the connecting part 7 is formed in the through groove P2. The conductive layer 5 and the connecting part 7 can be formed by a thin film forming method such as sputtering.

As shown in FIG. 3D, then, a metallic paste is printed on the conductive layer 5 in a pattern by a method such as screen printing and is heated and cured to form the linear electrode 6.

As shown in Fig. 3E, finally, the electrode layer is left and the first semiconductor layer 3, the second semiconductor layer 4, the conductive layer 5 and the linear electrode 6 are cut in a lump through scribing or the like. By the method, it is possible to easily fabricate the photoelectric conversion cell 20 comprising the structure in which the linear electrode 6 reaches the first end A of the photoelectric conversion layer PV in a planar view. In other words, in the case where the photoelectric conversion layer PV and the conductive layer 5 are formed and the through groove P2 is then formed, and the linear electrode 6 is formed in the respective portions between the through grooves P2, it is hard to align the first end A of the photoelectric conversion layer PV and the end of the linear electrode 6 with high precision. As a result, the linear electrode 6 is formed with a shift so that a failure is apt to occur. On the other hand, by carrying out the fabrication through the manufacturing method, it is possible to easily form the structure in which the linear electrode 6 reaches the first end A of the photoelectric conversion layer PV in a planar view. Consequently, it is possible to simplify the steps, and furthermore, to suppress the occurrence of the failure.

By carrying out the formation through the method described above, moreover, in the photoelectric conversion cells 20 which are adjacent to each other, the first electrode 2 of one of the photoelectric conversion cells 20 become one with the second electrode 8 of the other photoelectric conversion cell 20. Consequently, the photoelectric conversion cells 20 which are adjacent to each other are connected in series. Thus, it is possible to easily fabricate the photoelectric conversion module 21 obtained by arranging the photoelectric conversion cells 20 in a serial connection.

Next, description will be given to a photoelectric conversion cell and a photoelectric conversion module according to a second embodiment of the present invention.

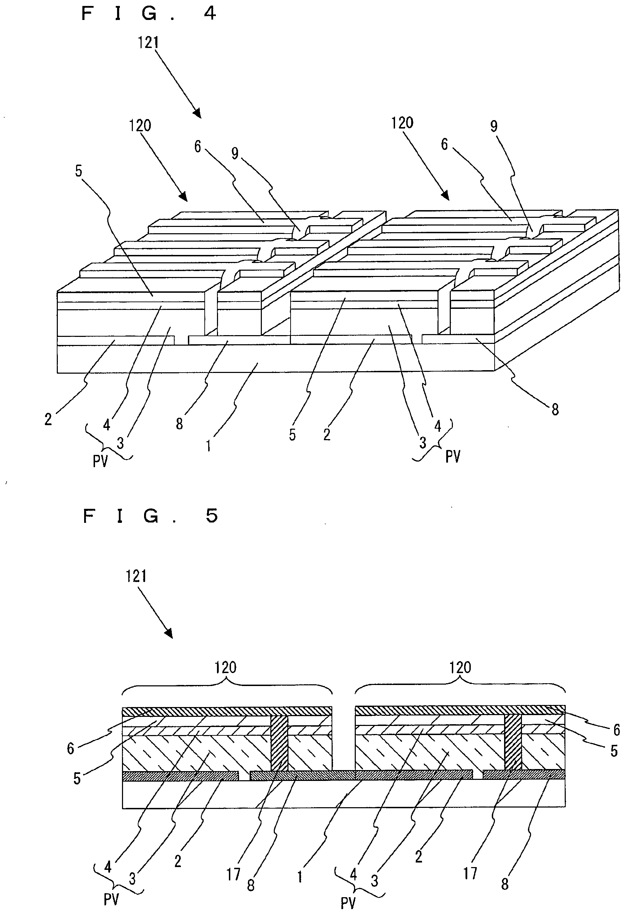

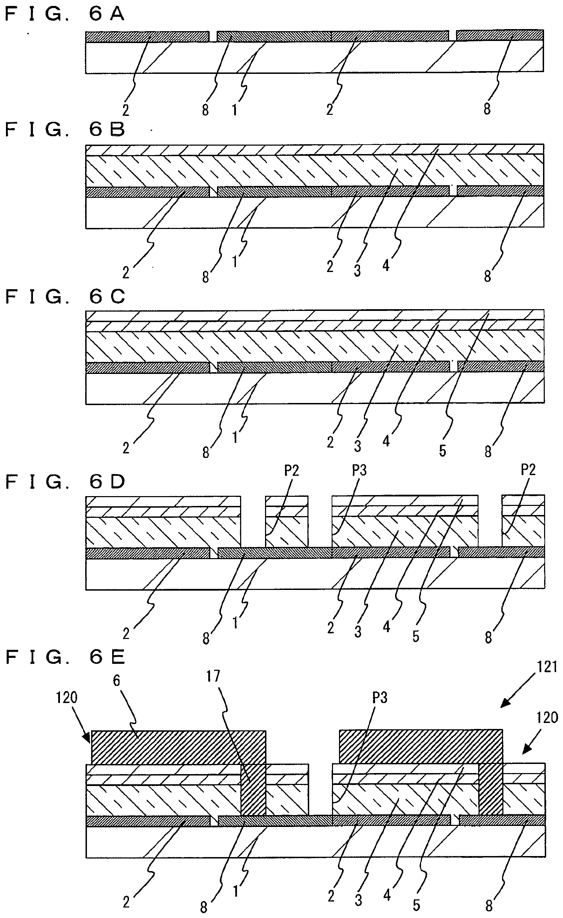

FIG. 4 is a view showing a structure of a photoelectric conversion cell 120 and a photoelectric conversion module 121 according to the second embodiment of the present invention. Moreover, FIG. 5 is a sectional view showing the photoelectric conversion cell 120 and the photoelectric conversion module 121, and FIGS. 6A to 6E are sectional views showing steps of a manufacturing method, respectively. In FIGS. 4 to 6, the same components as those of the photoelectric conversion cell 20 and the photoelectric conversion module 21 according to the first embodiment shown in FIGS. 1 to 3 have the same reference numerals and the same structures as those described above can be applied.

The photoelectric conversion cell 120 and the photoelectric conversion module 121 according to the second embodiment are different from the photoelectric conversion cell 20 and the photoelectric conversion module 21 according to the first embodiment in that a linear electrode 6 comprises a second extended portion extended from a second semiconductor layer 4 toward a second electrode layer 8, and the second extended portion is connected to the second electrode layer 8 so that the linear electrode 6 constitutes a connecting part 17. In the case where the linear electrode 6 is connected to the second electrode layer 8 to constitute the connecting part 17, thus, the connection is made more reliable so that a connecting reliability can be enhanced.

An example of how the second extended portion can be fabricated in a photoelectric conversion cell and a photoelectric conversion module similar to the ones of Fig. 4 and 5 is the following.

First of all, as shown in FIG. 6A, a first electrode layer 2 and a second electrode layer 8 in a desirable pattern are formed on a substrate 1. As shown in FIG. 6B, next, a first semiconductor layer 3 and a second semiconductor layer 4 are laminated on the substrate 1, the first electrode layer 2 and the second electrode layer 8. As shown in FIG. 6C, then, a conductive layer 5 is formed on the second semiconductor layer 4. As shown in FIG. 6D, thereafter, a through groove P2 for forming the connecting part 17 and a through groove P3 for separating the photoelectric conversion cells 120 are formed by scribing, etching or the like. As shown in FIG. 6E, finally, a metallic paste is printed in a pattern on the conductive layer 5 and a part of the through groove P2 by a method such as screen printing. Subsequently, the metallic paste is heated and cured to form a linear electrode 6.

Thus, the first semiconductor layer 3, the second semiconductor layer 4 and the conductive layer 5 are formed continuously and the through groove P2 for forming the connecting part 17 and the through groove P3 for separating the photoelectric conversion cells 120 are then formed at the same time. Consequently, a groove processing step can be simplified so that a productivity can be enhanced.

The present invention is not restricted to the embodiments but various changes may be carried out.

### EXPLANATION OF SYMBOLS

2: first electrode layer
3: first semiconductor layer
4: second semiconductor layer
5: conductive layer
6: linear electrode
7, 17: connecting part
8: second electrode layer
20, 120: photoelectric conversion cell
21, 121: photoelectric conversion module

## Claims

1. A photoelectric conversion cell (20,120) comprising:
a first electrode layer (2) and a second electrode layer (8) which are positioned at the same level and positioned apart from each other at an interval in a first direction;
a first semiconductor layer (3) positioned on the first and second electrode layers and having a first conductivity type;
a second semiconductor layer (4) which is positioned directly on the first semiconductor layer and has a second conductivity type, the second semiconductor layer forming pn junction and constituting a photoelectric conversion layer (PV) with the first semiconductor layer, the first and the second semiconductor layers comprising a first end in the first direction above the first electrode layer and a second end opposed to the first end above the second electrode layer;
a transparent conductive layer (5) positioned on the second semiconductor layer;
a connecting part (7,17) for electrically connecting the second semiconductor layer to the second electrode layer, the connecting part being provided closer to the second end than the first end; and
a plurality of linear electrodes (6) which are positioned directly on the transparent conductive layer,
**characterized in that**
the linear electrodes reach the first end of the second semiconductor layer from the connecting part in a planar view as viewed from the transparent conductive layer side,
wherein an end face of the linear electrodes, an end face of the transparent conductive layer (5) and an end face of the photoelectric conversion layer (PV) are coplanar at the first end (A) side.

2. The photoelectric conversion cell according to claim 1, wherein the connecting part is almost parallel with the second end and is extended linearly in a planar view as viewed from the transparent conductive layer side.

3. The photoelectric conversion cell according to claim 1, wherein the transparent conductive layer comprises a first extended portion extended from the second semiconductor layer toward the second electrode layer, and the first extended portion is connected to the second electrode layer so that the transparent conductive layer constitutes the connecting part (7).

4. The photoelectric conversion cell according to claim 1, wherein the linear electrodes comprise a second extended portion extended from the second semiconductor layer toward the second electrode layer, and the second extended portion is connected to the second electrode layer so that the linear electrodes constitute the connecting part (17).

5. The photoelectric conversion cell according to claim 1, wherein the linear electrodes contain metallic particles and a resin.

6. The photoelectric conversion cell according to claim 1, wherein the photo-electric conversion layer contains a chalcopyrite type material.

7. A photoelectric conversion module (21,121) comprising:
a plurality of the photoelectric conversion cells according to claim 1, wherein, the photoelectric conversion cells comprise a first photoelectric conversion cell and a second photoelectric conversion cell,
the first and second photoelectric conversion cells comprise the first and second electrode layers positioned in the same direction respectively, and the second electrode layer of the first photoelectric conversion cell and the first electrode layer of the second photoelectric conversion cell are electrically connected to each other.

8. A method for manufacturing a photoelectric conversion cell comprising a first electrode layer (2) and a second electrode layer (8) which are positioned at the same level and positioned apart from each other at an interval in a first direction; a first semiconductor layer (3) positioned on the first and second electrode layers and having a first conductivity type; a second semiconductor layer (4) which is positioned on the first semiconductor layer and has a second conductivity type different from the first conductivity type, the first semiconductor layer and the second semiconductor layer constituting a photoelectric conversion layer, the first and the second semiconductor layers comprising a first end in the first direction above the first electrode layer and a second end opposed to the first end above the second electrode layer; a transparent conductive layer (5) positioned on the second semiconductor layer; a connecting part (7,17) for electrically connecting the second semiconductor layer to the second electrode layer, the connecting part being provided closer to the second end than the first end; and a plurality of linear electrodes (6) which are positioned directly on the transparent conductive layer, wherein the linear electrodes reach the first end of the second semiconductor layer from the connecting part in a planar view as viewed from the transparent conductive layer side; the method comprising:
forming the spaced apart first and second electrode layers at the same level;
laminating the first semiconductor layer, the second semiconductor layer, the transparent conductive layer and the plurality of linear electrodes on the first and second electrode layers in this order; and
cutting the first semiconductor layer, the second semiconductor layer, the transparent conductive layer and the linear electrodes at once.

## Patentansprüche

1. Eine photoelektrische Umwandlungszelle (20, 120), aufweisend:
eine erste Elektrodenschicht (2) und eine zweite Elektrodenschicht (8), die auf gleicher Höhe angeordnet sind und in einer ersten Richtung mit einem Abstand voneinander getrennt angeordnet sind;
eine erste Halbleiterschicht (3), die auf der ersten und der zweiten Elektrodenschicht angeordnet ist und einen ersten Leitfähigkeitstyp aufweist;
eine zweite Halbleiterschicht (4), die direkt auf der ersten Halbleiterschicht angeordnet ist und einen zweiten Leitfähigkeitstyp aufweist, wobei die zweite Halbleiterschicht mit der ersten Halbleiterschicht einen pn-Übergang ausbildet und eine photoelektrische Umwandlungsschicht (PV) ausbildet, wobei die erste und die zweite Halbleiterschicht ein erstes Ende in der ersten Richtung über der ersten Elektrodenschicht und ein zweites Ende, das dem ersten Ende entgegengesetzt ist, über der zweiten Elektrodenschicht aufweisen;
eine transparente leitfähige Schicht (5), die auf der zweiten Halbleiterschicht angeordnet ist;
einen Verbindungsteil (7, 17) zum elektrischen Verbinden der zweiten Halbleiterschicht mit der zweiten Elektrodenschicht, wobei der Verbindungsteil näher an dem zweiten Ende angeordnet ist als das erste Ende; und
eine Mehrzahl von linearen Elektroden (6), die direkt auf der transparenten leitfähigen Schicht angeordnet sind,
**dadurch gekennzeichnet, dass**
die linearen Elektroden in einer Draufsicht, von der Seite der transparenten leitfähigen Schicht aus gesehen, das erste Ende der zweiten Halbleiterschicht von dem Verbindungsteil aus erreichen,
wobei eine Endfläche der linearen Elektroden, eine Endfläche der transparenten leitfähigen Schicht (5) und eine Endfläche der photoelektrischen Umwandlungsschicht (PV) an der erste-Ende- (A) -Seite koplanar sind.

2. Die photoelektrische Umwandlungszelle gemäß Anspruch 1, wobei der Verbindungsteil in einer Draufsicht, von der Seite der transparenten leitfähigen Schicht aus gesehen, ungefähr parallel zu dem zweiten Ende ist und sich linear erstreckt.

3. Die photoelektrische Umwandlungszelle gemäß Anspruch 1, wobei die transparente leitfähige Schicht einen ersten Erstreckungsabschnitt aufweist, der sich von der zweiten Halbleiterschicht in Richtung zu der zweiten Elektrodenschicht erstreckt, und der erste Erstreckungsabschnitt mit der zweiten Elektrodenschicht verbunden ist, so dass die transparente leitfähige Schicht den Verbindungsteil (7) bildet.

4. Die photoelektrische Umwandlungszelle gemäß Anspruch 1, wobei die linearen Elektroden einen zweiten Erstreckungsabschnitt aufweisen, der sich von der zweiten Halbleiterschicht in Richtung zu der zweiten Elektrodenschicht erstreckt, und der zweite Erstreckungsabschnitt mit der zweiten Elektrodenschicht verbunden ist, so dass die linearen Elektroden den Verbindungsteil (17) bilden.

5. Die photoelektrische Umwandlungszelle gemäß Anspruch 1, wobei die linearen Elektroden metallische Partikel und ein Harz enthalten.

6. Die photoelektrische Umwandlungszelle gemäß Anspruch 1, wobei die photoelektrische Umwandlungsschicht ein Material vom Chalcopyrit-Typ enthält.

7. Ein photoelektrisches Umwandlungsmodul (21, 121), aufweisend:
eine Mehrzahl der photoelektrischen Umwandlungszellen gemäß Anspruch 1,
wobei die photoelektrischen Umwandlungszellen eine erste photoelektrische Umwandlungszelle und eine zweite photoelektrische Umwandlungszelle aufweisen,
die erste und die zweite photoelektrische Umwandlungszelle die erste und die zweite Elektrodenschicht in der jeweils gleichen Richtung angeordnet aufweisen und die zweite Elektrodenschicht der ersten photoelektrischen Umwandlungszelle und die erste Elektrodenschicht der zweiten photoelektrischen Umwandlungszelle elektrisch miteinander verbunden sind.

8. Ein Verfahren zum Herstellen einer photoelektrischen Umwandlungszelle, aufweisend eine erste Elektrodenschicht (2) und eine zweite Elektrodenschicht (8), die auf gleicher Höhe angeordnet sind und in einer ersten Richtung mit einem Abstand voneinander getrennt angeordnet sind; eine erste Halbleiterschicht (3), die auf der ersten und der zweiten Elektrodenschicht angeordnet ist und einen ersten Leitfähigkeitstyp aufweist; eine zweite Halbleiterschicht (4), die auf der ersten Halbleiterschicht angeordnet ist und einen zweiten Leitfähigkeitstyp aufweist, der sich von dem ersten Leitfähigkeitstyp unterscheidet, wobei die erste Halbleiterschicht und die zweite Halbleiterschicht eine photoelektrische Umwandlungsschicht ausbilden, wobei die erste und die zweite Halbleiterschicht ein erstes Ende in der ersten Richtung über der ersten Elektrodenschicht und ein zweites Ende, das dem ersten Ende entgegengesetzt ist, über der zweiten Elektrodenschicht aufweisen; eine transparente leitfähige Schicht (5), die auf der zweiten Halbleiterschicht angeordnet ist; einen Verbindungsteil (7, 17) zum elektrischen Verbinden der zweiten Halbleiterschicht mit der zweiten Elektrodenschicht, wobei der Verbindungsteil näher an dem zweiten Ende angeordnet ist als das erste Ende; und eine Mehrzahl von linearen Elektroden (6), die direkt auf der transparenten leitfähigen Schicht angeordnet sind, wobei die linearen Elektroden in einer Draufsicht, von der Seite der transparenten leitfähigen Schicht aus gesehen, das erste Ende der zweiten Halbleiterschicht von dem Verbindungsteil aus erreichen, wobei das Verfahren aufweist:
Formen der ersten und der zweiten Elektrodenschicht, die voneinander getrennt sind, auf gleicher Höhe;
Laminieren der ersten Halbleiterschicht, der zweiten Halbleiterschicht, der transparenten leitfähigen Schicht und der Mehrzahl von linearen Elektroden auf die erste und die zweite Elektrodenschicht in dieser Reihenfolge; und
Schneiden der ersten Halbleiterschicht, der zweiten Halbleiterschicht, der transparenten leitfähigen Schicht und der linearen Elektroden gleichzeitig / auf einmal.

## Revendications

1. Une cellule de conversion photoélectrique (20, 120) comprenant :
une première couche d'électrode (2) et une deuxième couche d'électrode (8) qui sont positionnées au même niveau et positionnées à l'écart l'une de l'autre avec un intervalle dans une première direction ;
une première couche semi-conductrice (3) positionnée sur les première et deuxième couches d'électrode et ayant un premier type de conductivité ;
une deuxième couche semi-conductrice (4) qui est directement positionnée sur la première couche semi-conductrice et a un deuxième type de conductivité, la deuxième couche semi-conductrice formant une jonction pn et constituant une couche de conversion photoélectrique (PV) avec la première couche semi-conductrice, la première et la deuxième couche semi-conductrice comprenant une première extrémité dans la première direction au-dessus de la première couche d'électrode et une deuxième extrémité à l'opposé de la première extrémité au-dessus de la deuxième couche d'électrode ;
une couche conductrice transparente (5) positionnée sur la deuxième couche semi-conductrice ;
une partie de raccordement (7, 17) pour raccorder électriquement la deuxième couche semi-conductrice à la deuxième couche d'électrode, la partie de raccordement étant disposée plus près de la deuxième extrémité que de la première extrémité ; et
une pluralité d'électrodes linéaires (6) qui sont positionnées directement sur la couche conductrice transparente,
**caractérisée en ce que**
les électrodes linéaires atteignent la première extrémité de la deuxième couche semi-conductrice depuis la partie de raccordement dans une vue en plan telle qu'observée depuis le côté de la couche conductrice transparente,
dans lequel une face d'extrémité des électrodes linéaires, une face d'extrémité de la couche conductrice transparente (5) et une face d'extrémité de la couche de conversion photoélectrique (PV) sont coplanaires sur le côté de la première extrémité (A).

2. La cellule de conversion photoélectrique selon la revendication 1, dans laquelle la partie de raccordement est presque parallèle à la deuxième extrémité et est prolongée linéairement dans une vue en plan telle qu'observée depuis le côté de la couche conductrice transparente.

3. La cellule de conversion photoélectrique selon la revendication 1, dans laquelle la couche conductrice transparente comprend une première partie prolongée, prolongée depuis la deuxième couche semi-conductrice vers la deuxième couche d'électrode, et la première partie prolongée est raccordée à la deuxième couche d'électrode de telle sorte que la couche conductrice transparente constitue la partie de raccordement (7).

4. La cellule de conversion photoélectrique selon la revendication 1, dans laquelle les électrodes linéaires comprennent une deuxième partie prolongée, prolongée depuis la deuxième couche semi-conductrice vers la deuxième couche d'électrode, et la deuxième partie prolongée est raccordée à la deuxième couche d'électrode de telle sorte que les électrodes linéaires constituent la partie de raccordement (17).

5. La cellule de conversion photoélectrique selon la revendication 1, dans laquelle les électrodes linéaires contiennent des particules métalliques et une résine.

6. La cellule de conversion photoélectrique selon la revendication 1, dans laquelle la couche de conversion photoélectrique contient un matériau de type chalcopyrite.

7. Un module de conversion photoélectrique (21, 121) comprenant :
une pluralité de cellules de conversion photoélectrique selon la revendication 1,
les cellules de conversion photoélectrique comprenant une première cellule de conversion photoélectrique et une deuxième cellule de conversion photoélectrique,
les première et deuxième cellules de conversion photoélectrique comprenant les première et deuxième couches d'électrode respectivement positionnées dans la même direction, et la deuxième couche d'électrode de la première cellule de conversion photoélectrique et la première couche d'électrode de la deuxième cellule de conversion photoélectrique étant raccordées électriquement l'une à l'autre.

8. Un procédé de fabrication d'une cellule de conversion photoélectrique comprenant une première couche d'électrode (2) et une deuxième couche d'électrode (8) qui sont positionnées au même niveau et positionnées à l'écart l'une de l'autre avec un intervalle dans une première direction ; une première couche semi-conductrice (3) positionnée sur les première et deuxième couches d'électrode et ayant un premier type de conductivité ; une deuxième couche semi-conductrice (4) qui est positionnée sur la première couche semi-conductrice et a un deuxième type de conductivité différent du premier type de conductivité, la première couche semi-conductrice et la deuxième couche semi-conductrice constituant une couche de conversion photoélectrique, la première et la deuxième couche semi-conductrice comprenant une première extrémité dans la première direction au-dessus de la première couche d'électrode et une deuxième extrémité à l'opposé de la première extrémité au-dessus de la deuxième couche d'électrode ; une couche conductrice transparente (5) positionnée sur la deuxième couche semi-conductrice ; une partie de raccordement (7, 17) pour raccorder électriquement la deuxième couche semi-conductrice à la deuxième couche d'électrode, la partie de raccordement étant disposée plus près de la deuxième extrémité que de la première extrémité ; et une pluralité d'électrodes linéaires (6) qui sont positionnées directement sur la couche conductrice transparente, où les électrodes linéaires atteignent la première extrémité de la deuxième couche semi-conductrice depuis la partie de raccordement dans une vue en plan telle qu'observée depuis le côté de la couche conductrice transparente ; le procédé comprenant les étapes suivantes consistant à :
former les première et deuxième couches d'électrode espacées au même niveau ;
laminer la première couche semi-conductrice, la deuxième couche semi-conductrice, la couche conductrice transparente et la pluralité d'électrodes linéaires sur les première et deuxième couches d'électrode dans cet ordre ; et
découper simultanément la première couche semi-conductrice, la deuxième couche semi-conductrice, la couche conductrice transparente et les électrodes linéaires.
